# FASCICULE DE BREVET EUROPEEN

(11) **EP 4 188 052 B1**
(45) Date de publication et mention de la délivrance du brevet: **09.07.2025**
(21) Numéro de dépôt: 22209287.6
(22) Date de dépôt: 24.11.2022
(51) Int. Cl.: H10K 30/57, H10K 71/10, H10K 85/20, H10K 85/50, H10K 85/60

(54) **CELLULE SOLAIRE TANDEM EN SILICIUM ET PÉROVSKITE**
SILICIUM- UND PEROWSKIT-TANDEMSOLARZELLE
PEROVSKITE SILICON TANDEM SOLAR CELL

(30) Priorité: 30.11.2021 FR 2112745
(43) Date de publication de la demande: 31.05.2023
(73) Titulaire: Commissariat à l'Energie Atomique et aux Energies Alternatives, 75015 Paris (FR)
(72) Inventeur: MATHERON, Muriel, 38054 Grenoble cedex 09 (FR); DANEL, Adrien, 38054 Grenoble cedex 09 (FR); LIGNIER, Hélène, 38054 Grenoble cedex 09 (FR)
(74) Mandataire: Germain Maureau

(56) Documents cités:
- DE-B3- 102019 116 851
- FILIPE MARTINHO: "Challenges for the future of tandem photovoltaics on the path to terawatt levels: A technology review", ARXIV.ORG, CORNELL UNIVERSITY LIBRARY, 201 OLIN LIBRARY CORNELL UNIVERSITY ITHACA, NY 14853, 20 February 2021 (2021-02-20), XP081889492
- VALLES-PELARDA MARTA ET AL: "Analysis of the Hysteresis Behavior of Perovskite Solar Cells with Interfacial Fullerene Self-Assembled Monolayers", JOURNAL OF PHYSICAL CHEMISTRY LETTERS, vol. 7, no. 22, 3 November 2016 (2016-11-03), US, pages 4622 - 4628, XP055968224, ISSN: 1948-7185, DOI: 10.1021/acs.jpclett.6b02103

## Description

La présente invention se rapporte au domaine photovoltaïque, notamment au domaine des cellules tandem à base de silicium et de pérovskite. La présente invention concerne plus particulièrement une structure multicouche destinée à former une cellule photovoltaïque tandem à deux terminaux. Selon un deuxième aspect, l'invention se rapporte au procédé de fabrication d'une telle structure multicouche.

Les cellules solaires comprenant une couche d'absorption en pérovskite ont à ce jour dépassé des rendements de plus de 25% d'efficacité. En raison de la bande interdite optiquement réglable, des procédés de fabrication potentiellement bas coûts, et des rendements élevés, les couches absorbantes en pérovskite sont le partenaire idéal pour une intégration en tandem en tant que sous-cellule supérieure (c'est à dire la cellule solaire partielle face à la lumière dans la cellule solaire tandem) avec des sous-cellules inférieures en divers matériaux et notamment en silicium.

Habituellement, les couches d'interface disposées entre les deux sous-cellules en tandem sont constituées de dépôts d'oxydes de métaux de transition ou de polymères organiques conjugués. Ces dépôts peuvent être effectués par voie liquide ou par voie sèche. Mais ces solutions présentent des inconvénients suivants :
- une absorption optique non négligeable du fait d'une épaisseur classiquement comprise entre 30 et 50 nm des couches d'interface. Il s'ensuit des pertes par absorption parasite (i.e. moins de courant produit par la cellule solaire).
- un manque de conformité des dépôts, ces dépôts étant typiquement réalisés sur une sous-cellule inférieure de silicium issue d'un polissage chimique, ou texturée sur la face avant. Les couches déposées peuvent être discontinues, de qualité inhomogène, ce qui se traduit par des performances inhomogènes ou l'apparition de court-circuits.

DE 10 2019 116851 B3 décrit une cellule solaire multifonctions comprenant une sous cellule inférieure en silicium et une sous cellule supérieure en pérovskite entre lesquelles un empilement d'au moins deux couches A et B sont déposées. Ces couches peuvent constituer une jonction à effet tunnel et la couche A peut être une couche SAM déposée de façon conforme sur la couche B.

Un des buts de la présente invention est de pallier au moins l'un des inconvénients précités. A cet effet, la présente invention propose une structure multicouche destinée à former une cellule photovoltaïque tandem, la structure multicouche comprenant :
- une sous-cellule inférieure à base de silicium,
- une sous-cellule supérieure à base de pérovskite,
- une jonction à effet tunnel comportant du silicium dopé disposé à l'interface de la sous-cellule inférieure et de la sous-cellule supérieure,
la sous-cellule supérieure comprenant une couche inférieure de transport de charges composée par une mono-couche de molécules auto-assemblées.

L'expression 'mono-couche de molécules auto-assemblées' est bien connue de l'homme du métier sous l'acronyme anglo saxon 'SAM' pour Self-Assembled Monolayer. De façon classique, la SAM est une mono-couche de molécules greffées en surface par une liaison forte, telle qu'une liaison covalente ou des interactions électrostatiques.

Dans le cadre de la présente invention, la mono-couche de molécules auto-assemblées est greffée avec le silicium de la jonction à effet tunnel par des liaisons covalentes Si-C.

Comme on le verra plus en détail ci-dessous, cette liaison covalente Si-C est formée par une réaction d'hydrosilylation d'un composé précurseur de la molécule greffée, avec les liaisons Si-H disponibles en surface du silicium. Le composé précurseur comprend un groupement d'ancrage formé par une liaison multiple C-C, de type alcène ou alcyne, qui réagit avec les liaisons Si-H sur la surface de silicium à fonctionnaliser, en formant des liaisons Si-C. La réaction est autolimitée par le nombre de sites Si-H réactifs accessibles. La mono-couche de molécules auto-assemblées ainsi formée selon la présente invention est ainsi conforme. La mono-couche recouvre uniformément la texture de la surface de Si qu'elle recouvre, de sorte que l'épaisseur de ladite mono-couche est la même en tout point. Elle suit la géométrie de la surface à l'échelle microscopique, quelle que soit la rugosité de la surface, évitant toute interruption pouvant conduire à un court-circuit électrique.

De plus, ladite mono-couche présente une épaisseur réduite, notamment inférieure ou égale à 10 nm. Cette épaisseur est tout au plus équivalente à la plus grande dimension de la molécule greffée. Ceci permet de limiter l'adsorption optique de l'interface et assure un meilleur rendement photovoltaïque.

Les liaisons Si-C formées sont de nature covalente et sont connues pour être extrêmement robustes du point de vue chimique et thermique.

Par ailleurs, ladite molécule greffée comprend également un groupement fonctionnel relié au groupement d'ancrage par une chaine carbonée créant un moment dipolaire. La nature et la charge du groupement fonctionnel permettent de jouer sur la force du moment dipolaire, ainsi que sur le travail de sortie de la surface de silicium fonctionnalisée. Le groupement fonctionnel influence également l'énergie de surface de la couche, de sorte à favoriser la croissance de la couche de pérovskite de la sous-cellule supérieure.

En outre, la chaine carbonée entre le groupement fonctionnel et le groupement d'ancrage permet d'orienter les molécules greffées, ce qui créé une orientation au moment dipolaire et permet d'obtenir une surface homogène du point de vue chimique et de l'énergie de surface. Par exemple l'existence de forces de Van der Waals intermoléculaires entre les chaines carbonées permet un alignement des molécules greffées les unes par rapport aux autres, cette « orientation » allant dans le sens d'un meilleur transfert de charges et d'une meilleure homogénéité des surfaces obtenues.

Selon une possibilité, la mono-couche de molécules auto-assemblées est constituée par des premiers fragments de formule I (avec R = H, Me, OMe et n = 1, 2 ou 3) ou de formule Il (avec R = H, Me, OMe et n = 1, 2 ou 3) reliés par des liaisons covalentes Si-C au silicium, de sorte à former une couche de transport de trous. Ces premiers fragments peuvent en effet jouer le rôle de transport de trous du fait de la localisation / délocalisation des électrons qui peut être étendue sur l'ensemble du système conjugué des premiers fragments.

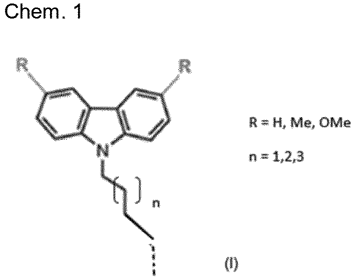

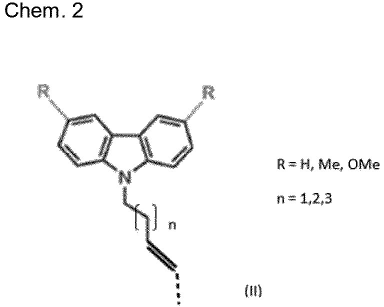

Selon une variante, la mono-couche de molécules auto-assemblées est constituée des deuxièmes fragments de formules III à VI reliés par des liaisons covalentes Si-C au silicium, de sorte à former une couche de transport d'électrons, tel que décrit dans l'article de revue de K Choi et al. Sol. RRL 2020, 4, 1900251. Ces seconds fragments sont en effet favorables à la conduction des électrons.

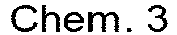

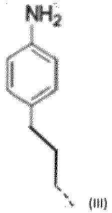

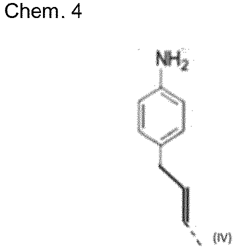

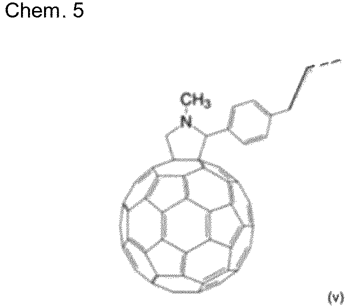

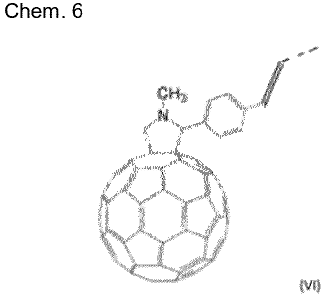

Selon une disposition, le silicium de la jonction à effet tunnel est choisi parmi du silicium amorphe hydrogéné et dopé, du silicium polycristallin hydrogéné et dopé, du silicium microcristallin hydrogéné et dopé ou du silicium nanocristallin hydrogéné et dopé, du silicium nanocristallin oxygéné hydrogéné et dopé (nc-SiOx :H) ou du silicium nanocristallin carboné hydrogéné et dopé (nc-SiCx :H). Dans le cas du silicium nanocristallin oxygéné hydrogéné et dopé « nc-SiOx :H », il est entendu dans le présent document qu'il s'agit d'un matériau composé avant tout de cristaux de silicium, et d'une partie de silice destinée à baisser son indice de réfraction. Ce matériau est donc bien différent de l'oxyde natif SiOx.

Bien entendu, le silicium mis en jeu dans la réaction d'hydrosilylation est dépourvu d'oxyde natif. Les laisons hydrogène Si-H présentes en surface sont rendues accessibles par un traitement de désoxydation pour permettre la réaction avec le composé précurseur de ladite mono-couche.

Selon une disposition, la jonction à effet tunnel comprend une couche inférieure et une couche supérieure, au moins l'une de la couche supérieure et de la couche inférieure est une couche de type n ou une couche de type p. Selon la configuration NIP ou PIN de la cellule photovoltaïque, la mono-couche de molécules auto-assemblées est choisie pour former une couche de transport d'électrons ou pour former une couche de transport de trou, que la couche sous jacente de la jonction à effet tunnel soit de type p ou de type n.

Selon une réalisation particulière, la couche inférieure est une couche de type n ou une couche de type p et la mono-couche de molécules auto-assemblées forme au moins en partie la couche supérieure de la jonction à effet tunnel. Autrement dit, ladite mono-couche forme une couche de transport de charge en même temps qu'elle joue le rôle de couche supérieure de la jonction à effet tunnel. Ainsi, la couche supérieure de la jonction à effet tunnel est une couche de transport de trou constituée par une mono-couche de molécules auto-assemblées contenant les premiers fragments de formule I ou de formule Il lorsqu'elle est formée sur une couche inférieure de type n. La couche supérieure est une couche de transport d'électrons constituée par une mono-couche de molécules auto-assemblées contenant des deuxièmes fragments choisis parmi les formules III à VI lorsqu'elle est formée sur une couche inférieure de type p.

Selon une autre possibilité, la couche inférieure de la jonction à effet tunnel forme une couche de sélection des charges de la sous-cellule inférieure de silicium. Il est alors possible d'obtenir une architecture simplifiée dans laquelle la couche inférieure de la jonction à effet tunnel est réalisée par une couche de sélection des charges de la sous-cellule inférieure et la couche supérieure de la jonction à effet tunnel est réalisée par une couche de transport des charges de la sous-cellule de pérovskite.

Selon une autre variante, la couche supérieure et la couche inférieure sont respectivement une couche de type n ou une couche de type p ou inversement.

Selon une possibilité la structure multicouche comprend :
- une sous-cellule inférieure à base de silicium,
- une sous-cellule supérieure à base de pérovskite,
- une jonction à effet tunnel comportant du silicium dopé disposé à l'interface de la sous-cellule inférieure et de la sous-cellule supérieure,
la sous-cellule supérieure comprenant une couche inférieure de transport de charges composée par une mono-couche de molécules auto-assemblées, la mono-couche de molécules auto-assemblées est greffée avec le silicium dopé de la jonction à effet tunnel par des liaisons covalentes Si-C.

Selon un deuxième aspect, la présente invention propose un procédé de fabrication de la structure multicouche telle que précédemment décrite, le procédé comprenant les étapes de :
- a) founiture de la sous-cellule inférieure à base de silicium,
- b) dépôt d'au moins la couche de silicium dopé et hydrogéné pour former au moins la couche inférieure ou la couche supérieure de la jonction à effet tunnel,
- c) formation de la mono-couche de molécules auto-assemblées de sorte à former la couche de transport de charges,
- d) dépôt de la couche de pérovskite sur la mono-couche de molécules auto-assemblées.

Une couche de transport de charges conforme et peu absorbante (du flux lumineux) est ainsi facilement formée entre les deux sous-cellules.

Selon une possibilité, la sous-cellule inférieure fournie à l'étape a) comprend au moins un substrat en silicium, des couches de passivation et une couche de sélection de charge de la sous-cellule inférieure.

Selon une disposition, le procédé comprend également le dépôt d'une deuxième couche de transport de charges sur la couche de pérovskite de sorte à finaliser la sous-cellule supérieure.

Cette étape est suivie par le dépôt d'une couche de TCO (oxyde conducteur transparent) avant de former des contacts métalliques en face avant et en face arrière de la cellulle photovoltaïque tandem.

De manière concrète, avant la formation de la mono-couche de molécules auto-assemblées de l'étape c), le procédé comprend une étape i) d'application d'un traitement de la surface de silicium de la jonction à effet tunnel par une solution aqueuse d'un mélange de HF à 2% et HCl à 1% de sorte à retirer l'oxyde natif.

Le traitement de l'étape i) permet avantageusement de rendre accessibles toutes les liaisons Si-H de la surface de silicium en vue de réaliser l'hydrosilylation.

La solution aqueuse permet le retrait de l'oxyde natif et également des contaminants.

L'étape i) est réalisée pendant une durée de quelques dizaines de secondes, par exemple sur une durée d'environ 60 secondes.

L'étape c) du procédé comprend l'hydrosilylation d'un composé précurseur choisi parmi les premiers composés précurseurs de formule P.I ou P.II (avec R = H, Me, OMe et n = 1, 2 ou 3) et les deuxièmes composés précurseurs de formule P.III à P.VI sur la surface de silicium hydrogéné de sorte à obtenir la mono-couche de molécules auto-assemblées.

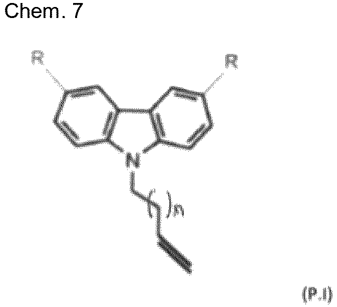

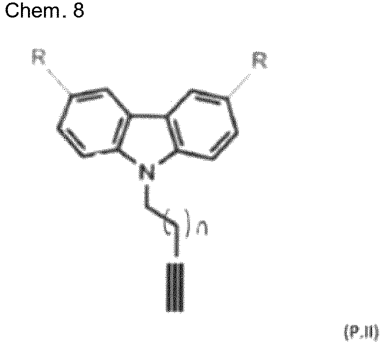

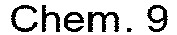

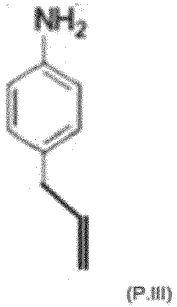

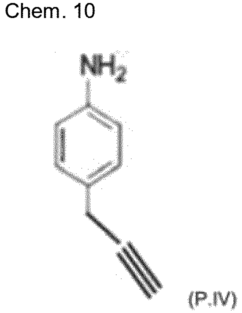

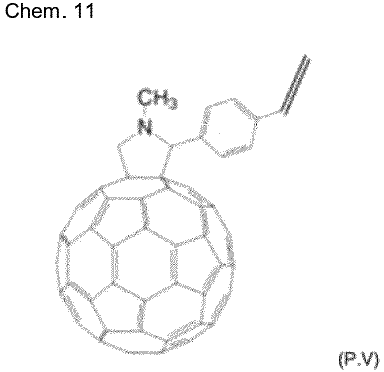

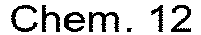

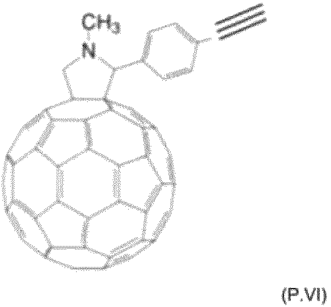

Selon une possibilité, l'hydrosilylation est obtenue par une réaction radicalaire activée par un traitement thermique.

De manière concrète, au moins la surface de silicium hydrogénée est placée en présence d'un composé précurseur sous atmosphère inerte et l'ensemble est chauffé à une température comprise entre 130 et 180°C pendant une durée de 12 à 18h de sorte à conduire à l'hydrosilylation.

Selon une disposition, l'étape b) du procédé comprend le dépôt d'une seule couche inférieure de la jonction à effet tunnel de silicium dopé et l'étape c) comprend la formation de la mono-couche de molécules auto-assemblées formant une couche de transport de charges et la couche supérieure de la jonction à effet tunnel.

Selon d'autres caractéristiques, la structure multicouche de l'invention comporte une ou plusieurs des caractéristiques optionnelles suivantes considérées seules ou en combinaison :
- La structure multicouche est destinée à former une cellule photovoltaïque tandem à deux terminaux.
- La mono-couche de molécules auto-assemblées présente une épaisseur inférieure ou égale à 10 nm.
- La mono-couche de molécules auto-assemblées est à l'interface de la couche absorbante de pérovskite de la sous-cellule supérieure et de la jonction à effet tunnel.
- La mono-couche de molécules auto-assemblées est en contact direct avec la couche absorbante de pérovskite de la sous-cellule supérieure.
- La mono-couche de molécules auto-assemblées est en contact direct avec la couche inférieure ou la couche supérieure de la jonction à effet tunnel.
- La mono-couche de molécules auto-assemblées provient d'une réaction d'hydrosilylation avec les liaisons silicium-hydrogène à la surface de la couche de silicium dopé hydrogéné, éventuellement amorphe, microcristallin, nanocristallin, nanocristallin oxygéné hydrogéné ou nc-SiCx : H sous-jacente. La couche sous-jacente constitue l'une de la couche inférieure et de la couche supérieure de la jonction à effet tunnel.
- Les molécules auto-assemblées forment des liaisons covalentes silicium - carbone avec les atomes de silicium sous-jacents.
- Les liaisons covalentes sont formées par hydrosilylation.
- Le silicium dopé de la jonction à effet tunnel avec lequel la monocouche de molécules autoassemblée est greffée, présente une surface désoxydée.
- Le silicium dopé de la jonction à effet tunnel avec lequel la monocouche de molécules autoassemblée est greffée, est nettoyé de son oxyde natif.
- La surface de la couche de silicium dopé à l'interface entre la sous-cellule inférieure et la sous-cellule supérieure est dépourvue d'oxyde natif.
- Le premier composé précurseur et le deuxième composé précurseur de la mono-couche de molécules auto-assemblées sont définis respectivement par les formules P.I ou P.II et P.III à P.VI correspondant respectivement aux molécules des premiers fragments de formule I ou Il et des deuxièmes fragments de formules III à VI.
- La couche de type n de la jonction à effet tunnel est une couche de silicium comprenant entre 10^{e}19 at/cm3 et 10^{e}21 at/cm3 de phosphore.
- La couche de type p de la jonction à effet tunnel est une couche de silicium comprenant entre 10^{e}19 at/cm3 et 10^{e}20 at/cm3 de bore.
- La mono-couche de molécules auto-assemblées constitue la totalité de la couche supérieure de la jonction à effet tunnel.
- La couche de transport de charges est conforme à la morphologie de la surface du silicium de la jonction à effet tunnel.
- La surface du silicium est globalement plane et ladite mono-couche est également globalement plane.
- La surface du silicium est obtenue par polissage CMP (rugosité < 10 nm ), ou par polissage chimique (topologie en surface de l'ordre du microns de haut sur quelques dizaines de microns de large), ou texturée (avec des morphologies de l'ordre de quelques µm en hauteur et en largeur).
- La couche inférieure de la jonction à effet tunnel est formée par dépôt PECVD par exemple pour le silicium microcristallin hydrogéné sur la sous-cellule inférieure de la structure multicouche.
- La couche inférieure et/ou la couche supérieure en silicium de la jonction à effet tunnel présente chacune une épaisseur comprise entre 10 et 100 nm.
- La couche de pérovskite est déposée sur une épaisseur comprise entre 200 et 1000 nm par voie chimique humide (procédés spin coating ou impression).
- La couche de pérovskite est déposée par voie sèche par dépôt sous vide ou par voie mixte (évaporation de Pbl2 puis imprégnation par voie liquide des précurseurs de pérovskite).
- La sous-cellule inférieure à base de silicium comprend des couches de passivation en silicium amorphe hydrogéné non dopé ou en oxyde de silicium.

Le terme « pérovskite » dans le présent document fait référence à la « structure pérovskite » et non spécifiquement au matériau pérovskite CaTiO3. Aux fins de la présente description, « pérovskite » comprend et désigne de préférence tout matériau qui a le même type de structure cristalline que l'oxyde de calcium-titane et les matériaux dans lesquels le cation divalent est remplacé par deux cations monovalents séparés. La structure pérovskite présente en général une stœchiométrie de type AMX3, où « A » et « M » sont des cations et « X » est un anion.

Les cations « A » et « M » peuvent avoir des charges différentes et dans le minéral de pérovskite d'origine (CaTiO3), le cation A est divalent et le cation M est tétravalent. Les formules de pérovskite englobent des structures ayant un, deux, trois ou quatre cations, qui peuvent être identiques ou différents, et/ou un ou deux des anions et / ou des atomes de métal qui portent deux ou trois charges positives.

En outre le matériau de pérovskite organique-inorganique présente une structure de pérovskite de l'une des formules suivantes :
A1A2A3A4MX3, A1A2A3MX3, A1A2MX4 ; A1MX3 ; A1A2N2 / 3X4 ; A1N2 / 3X3 ; BN2 / 3X4 ; A12NMX6 ; BMX4, où
- A1, A2, A3, A4 sont soit des cations organiques monovalents, soit des mélanges de ceux-ci qui sont choisis indépendamment parmi les composés organiques d'ammonium primaires, secondaires, tertiaires ou quaternaires, y compris les hétérocycles et systèmes cycliques azotés. A et A' indépendamment l'un de l'autre ont 1 à 60 atomes de carbone et 1 à 20 hétéroatomes (tels que méthylammonium ou formamidinium) ou des cations inorganiques (tels que Na, K, Rb, Cs).
- B est un cation organique divalent choisi parmi les composés organiques d'ammonium primaires, secondaires, tertiaires ou quaternaires qui ont de 1 à 60 atomes de carbone et de 2 à 20 hétéroatomes et avec deux atomes d'azote chargés positivement ;
- M est un cation métallique divalent choisi dans le groupe constitué par Cu, Ni, Co2+, Fe2+, Mn2+, Cr2+, Pd2+, Cd2+, Ge2+, Sn2+, Pb2+, Eu2+ ou Yb2+ ;
- N est un cation métallique divalent choisi dans le groupe de Bi et Sb et,
- X est un anion indépendamment choisi parmi Cl ⁻ Br⁻, I⁻, NCS⁻, CN⁻ et NCO- et leur mélange.

D'autres caractéristiques et avantages apparaitront à la lecture de la description détaillée ci-après, de 7 exemples de mise en oeuvre non limitatifs, faite en référence aux figures annexées dans lesquelles :
La figure 1 représente une vue schématique d'une cellule photovoltaïque présentant une configuration PIN, comprenant une structure multicouche selon un premier mode de réalisation de l'invention.
La figure 2 représente une vue schématique d'une cellule photovoltaïque comprenant une structure multicouche selon un deuxième mode de réalisation de l'invention.
La figure 3 représente une vue schématique d'une cellule photovoltaïque comprenant une structure multicouche simplifiée de la structure multicouche du premier mode de réalisation de l'invention (troisième mode de réalisation).
La figure 4 représente une vue schématique d'une cellule photovoltaïque comprenant une structure multicouche simplifiée de la structure multicouche du deuxième mode de réalisation de l'invention (quatriètme mode de réalisation).
La figure 5 représente une vue schématique d'une cellule photovoltaïque comprenant une structure multicouche simplifiée selon un cinquième mode de réalisation de l'invention.
La figure 6 représente une vue schématique d'une cellule photovoltaïque comprenant une structure multicouche simpliée selon un sixième mode de réalisation de l'invention.
La figure 7 représente une vue schématique d'une cellule photovoltaïque selon le premier mode de réalisation de l'invention et présentant une configuration NIP.

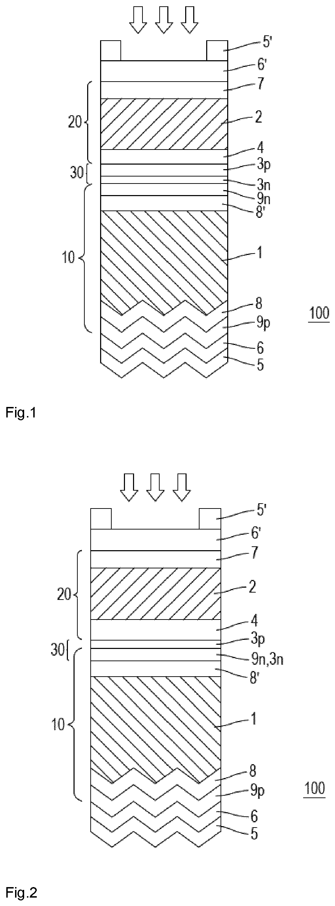

Les structures illustrées aux figures 1 à 7 représentent la structure multicouche selon l'invention mise en œuvre dans des cellules photovoltaiques.

La structure multicouche 100 de l'invention comprend une sous-cellule inférieure 10 comprenant un substrat en silicium 1 de c-Si (n), une sous-cellule supérieure 20 comprenant une couche absorbante de pérovskite 2, une jonction à effet tunnel 30, disposée à l'interface de la sous-cellule inférieure 10 et de la sous-cellule supérieure 20, à base de silicium, une couche de transport des charges 4 en face arrière de la sous-cellule supérieure 20 étant composée par une mono-couche de molécules auto-assemblées greffée sur le silicium de la jonction à effet tunnel 30.

Les cellules photovoltaïques formées à partir la structure multicouche 100 décrite ci-dessus comprennent en plus, un contact métallique pleine plaque 5 en argent sur une couche de TCO 6 (oxyde conducteur transparent) pour la prise de contact électrique en face arrière de la cellule. La structure multicouche 100 comprend également une couche de transport des charges 7 classique sur la couche absorbante de pérovskite 2 (coté face avant par rapport au flux lumineux), une couche de TCO 6' et un contact métallique grille 5' pour la prise de contact électrique face avant (dans la direction de la pénétration de la lumière).

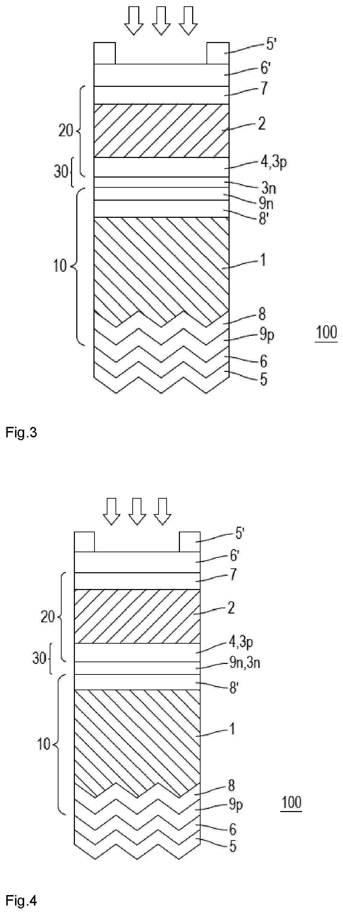

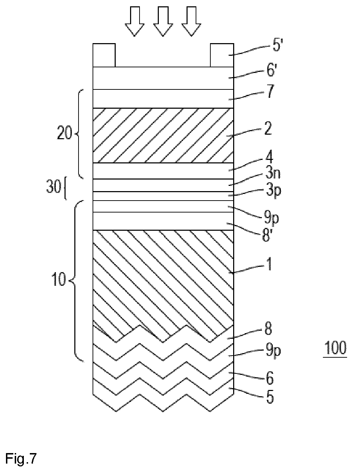

Comme illustré sur les figures 1 à 3, la sous-cellule inférieure 10 de silicium comprend de part et d'autre du substrat de silicium une couche de passivation 8, 8' réalisée conventionnellement en (i) a-Si :H (figures 1, 3, 5 et 7) ou en SiOx (figures 2 et 4). Une couche de sélection des charges p, 9p, en (p) a-Si :H (figure 1, 3 et 5 et 6) ou en Poly-Si (p+) (figure 2) couvre la couche de passivation en face arrière et une couche de sélection de charges n, 9n, respectivement en (n) a-Si :H (figures 1, 3 et 5 et 6) ou Poly-Si (n+) (figures 2 et 4) couvre la couche de passivation 8' en face avant dans une configuration de type PIN (figure 1). Les couches de sélection de charges 9p, 9n sont inversées dans une configuration de type NIP (figure 7).

A l'interface de la sous-cellule inférieure 10 de silicium et de la sous-cellule supérieure 20 de pérovskite, la structure 100 selon la présente invention comprend une jonction à effet tunnel 30 en silicium et une couche de transport de charge réalisée par une mono-couche de molécules auto assemblées 4 liée de façon covalente au silicium sous-jacent.

Comme illustré à la figure 1 illustrant une architecture de type PIN, la jonction à effet tunnel 30 est constituée d'une couche inférieure de type n, 3n, en silicium (n+) µc-Si :H et une couche supérieure de type p, 3p, en silicium (p+) µc-Si :H. Une mono-couche de molécules auto-assemblées 4 formant une couche de transport des trous de la sous-cellule supérieure 20 est formée par hydrosilylation d'un premier composé précurseur de formule P.I ou P.II sur les liaisons Si-H de la surface désoxydée de la couche supérieure de type p, 3p.

Selon une variante de réalisation illustrée à la figure 2, la couche de sélection des charges n, 9n, en Poly-Si : H (n+) de la sous-cellule inférieure 10 joue également le rôle de la couche inférieure 3n de la jonction à effet tunnel 30. Une couche supérieure 3p de la jonction à effet tunnel 30 est formée en Poly-Si : H (p+). Une mono-couche de molécules auto-assemblées 4 de premiers fragments de formule I ou Il est formée par hydrosilylation sur les liaisons Si :H de la couche supérieure de type p pour former une couche de transport de trous.

Selon encore une autre variante de réalisation illustrée à la figure 3, l'invention propose cette fois une architecture simplifiée de la structure multicouche 100 telle que précédemment décrite en relation avec la figure 1. Dans cette configuration simplifiée, la couche de transport de trous 4 est obtenue par hydrosilylation d'un premier composé précurseur de formule P.I ou P.II sur la couche inférieure 3n de type n de la jonction à effet tunnel 30. La couche de transport de trous joue le rôle de la couche de type p, 3p, de la jonction à effet tunnel 30.

Cette simplifcation (figure 4) est appliquée à la configuration de la figure 2 dans laquelle la couche inférieure de type n, 3n, de la jonction à effet tunnel 30 est obtenue par la couche de sélection des électrons 9n en Poly-Si : H (n+) de la sous-cellule inférieure 10. La couche de sélection des électrons 9n est couverte par la mono-couche de molécules auto-assemblées 4 (couche de transport de trous). Ainsi, les deux couches précitées forment respectivement la couche inférieure 3n et la couche supérieure 3 p de la jonction à effet tunnel 30.

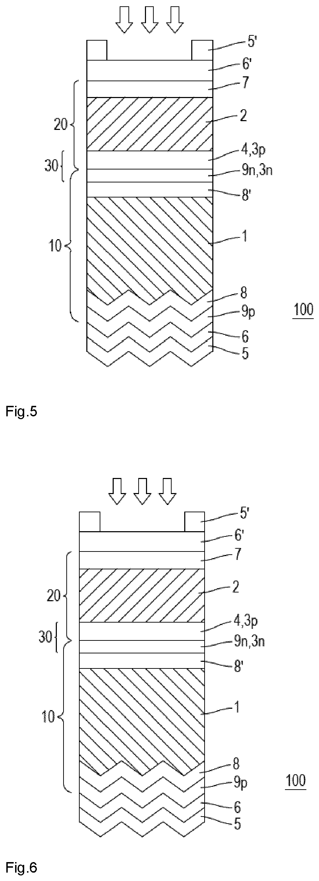

Cette même simplification (figure 5) est également apportée à la variante de la figure 3 dans laquelle la couche de sélection des électrons 9n, en (n) a-Si :H, forme la couche inférieure 3n de la jonction à effet tunnel 30 et la mono-couche de transport des trous 4 joue le rôle de la couche supérieure 3p de la jonction à effet tunnel 30.

La structure multicouche 100 simplifiée illustrée à la figure 6 diffère de celle de la figure 5, en ce que la couche de sélection des électrons 9n formant la couche inférieure de type n, 3n, de la jonction à effet tunnel est en (n+) nc-SiOx : H. (Selon une variante non illustrée, la couche inférieure est en nc-SiCx : H (n+)). Ce matériau présente une indice de réfraction intermédiaire entre celui de la couche absorbante de péroskite 2 et celui du substrat de silicium 1, ce qui permet de diminuer la réflexion parasite.

Les structures multicouches 100 peuvent être élaborées de sorte à produire une cellule d'une configuration de type PIN (figure 1 à 6) comme d'une configuration de type NIP (figure 7) sans modification notable de la mise en oeuvre de l'invention si ce n'est le choix du type de premier fragment de formule I et II ou de second fragment de formule III à VI des molécules greffées et des composés précurseurs utilisés pour la réaction d'hydrosilylation.

Selon le procédé de fabrication de la présente invention, la couche 3,9 de silicium hydrogéné dopé (éventuellement nc-SiOx ou nc-SiCx selon des variantes de réalisation) destinée à recevoir la couche de transport de charge 4 est tout d'abord nettoyée de son oxyde natif par un traitement selon une étape b) qui prévoit l'immersion de ladite couche dans une solution aqueuse de HF 2% et HCl 1% à température ambiante pendant environ 60 secondes. La surface désoxydée et présentant des liaisons Si-H accessibles est rincée à l'eau désionisée, puis est séchée à l'azote. La plaque ayant la couche désoxydée est tout de suite placée dans un réacteur préalablement purgé à l'azote et contenant le premier composé précurseur de formule P.I avec R = H avant d'être placé à 180°C pendant 16 heures de sorte à obtenir la mono-couche 4.

La plaque est ensuite rincée à l'hexane, au dichlorométhane et séchée sous azote.

Le dépot d'une couche absorbante de pérovskite 2 est ensuite réalisé par spin coating ou tout autre voie conventionnelle.

Ainsi configurée, la structure multicouche 100 de la présente invention comprend une mono-couche de molécules auto-assemblées 4 de faible absorption optique sur une couche de silicium 3, 9 de la jonction à effet tunnel 30. Elle est également une couche conforme quelle que soit la rugosité de la surface du silicium sous-jacent et présente un couplage fort réalisé par la création d'une liaison covalente Si-C robuste. De plus, ladite mono-couche 4 permet l'obtention d'une sélectivité via la formation et l'orientation d'un moment dipolaire en surface du système et cette couche présente une énergie de surface ajustable pour favoriser la mouillabilité et la croissance de la couche de pérovskite 2 sus-jacente.

## Revendications

1. Structure multicouche (100) destinée à former une cellule photovoltaïque tandem, la structure multicouche (100) comprenant :
- une sous-cellule inférieure (10) à base de silicium,
- une sous-cellule supérieure (20) à base de pérovskite,
- une jonction à effet tunnel (30) comportant du silicium dopé disposé à l'interface de la sous-cellule inférieure (10) et de la sous-cellule supérieure (20),
la sous-cellule supérieure (20) comprenant une couche inférieure de transport de charges (4) composée par une mono-couche de molécules auto-assemblées, **caractérisé en ce que** la mono-couche de molécules auto-assemblées (4) est greffée avec le silicium dopé de la jonction à effet tunnel (30) par des liaisons covalentes Si-C.

2. Structure multicouche (100) selon la revendication 1, dans laquelle le silicium de la jonction à effet tunnel (30) est choisi parmi du silicium amorphe hydrogéné et dopé, du silicium polycristallin hydrogéné et dopé, du silicium microcristallin hydrogéné et dopé, du silicium nanocristallin hydrogéné et dopé, du silicium nanocristallin oxygéné hydrogéné et dopé ou du silicium nanocristallin carboné hydrogéné et dopé.

3. Structure multicouche (100) selon l'une des revendications 1 à 2, dans laquelle la mono-couche de molécules auto-assemblées (4) est constituée de premiers fragments de formule I ou de formule II reliés par des liaisons covalentes au silicium, de sorte à former une couche de transport de trous.

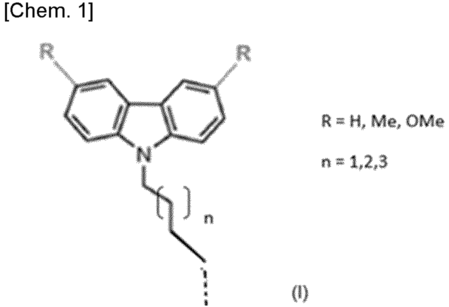

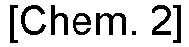

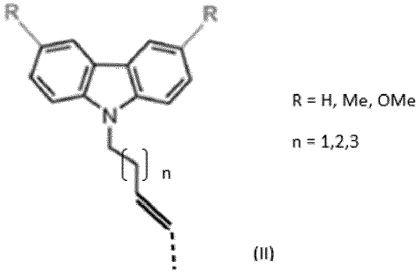

4. Structure multicouche (100) selon l'une des revendications 1 à 2, dans laquelle la mono-couche de molécules auto-assemblées (4) est constituée de deuxièmes fragments de formule III à VI reliés par des liaisons covalentes au silicium, de sorte à former une couche de transport d'électrons.

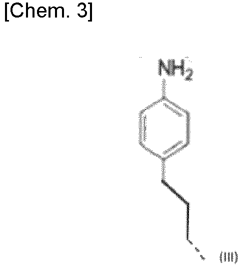

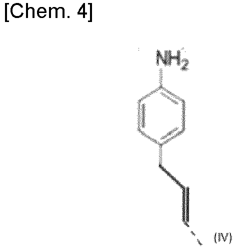

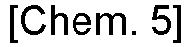

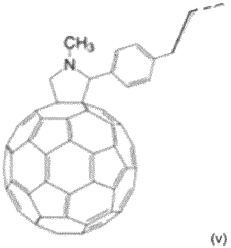

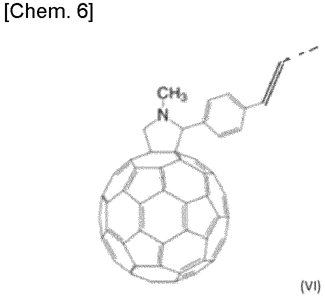

5. Structure multicouche (100) selon l'une des revendications 1 à 4, dans laquelle la jonction à effet tunnel (30) comprend une couche inférieure et une couche supérieure, au moins l'une de la couche supérieure et de la couche inférieure est une couche de type n (3n) ou une couche de type p (3p).

6. Structure multicouche (100) selon la revendication 5, dans laquelle la couche inférieure de la jonction à effet tunnel (30) est une couche de type n (3n) ou une couche de type p (3p) et la mono-couche de molécules auto-assemblées (4) forme au moins en partie la couche supérieure.

7. Structure multicouche (100) selon l'une des revendications 5 à 6, dans laquelle la couche inférieure de la jonction à effet tunnel (30) forme une couche de sélection des charges (9n, 9p) de la sous-cellule inférieure (10) de silicium.

8. Structure multicouche (100) selon l'une des revendications 1 à 7, dans laquelle la surface de la couche de silicium dopé à l'interface entre la sous-cellule inférieure (10) et la sous cellule supérieure (20) est dépourvue d'oxyde natif.

9. Procédé de fabrication de la structure multicouche (100) selon la revendication 1 à 8, le procédé comprenant les étapes de :
- a) founiture de la sous-cellule inférieure (10) à base de silicium,
- b) dépôt d'au moins la couche de silicium dopé et hydrogéné pour former au moins la couche inférieure ou la couche supérieure (3n, 3p) de la jonction à effet tunnel (30),
- c) formation de la mono-couche de molécules auto-assemblées (4) de sorte à former la couche de transport de charges,
- d) dépôt de la couche de pérovskite (2) sur la mono-couche de molécules auto-assemblées (4).

10. Procédé de fabrication de la structure multicouche (100) selon la revendication 9 comprenant, avant la formation de la mono-couche de molécules auto-assemblées (4) de l'étape c), une étape i) d'application d'un traitement de la surface de silicium par une solution aqueuse d'un mélange de HF à 2% et HCl à 1%, de sorte à retirer l'oxyde natif.

## Patentansprüche

1. Mehrschichtstruktur (100), die dazu bestimmt ist, eine Tandem-Photovoltaikzelle zu bilden, wobei die Mehrschichtstruktur (100) umfasst:
- eine untere Teilzelle (10) auf Siliziumbasis,
- eine obere Teilzelle (20) auf Perowskitbasis,
- einen Tunnelübergang (30), der dotiertes Silizium umfasst, das an der Grenzfläche der unteren Teilzelle (10) und der oberen Teilzelle (20) angeordnet ist,
wobei die obere Teilzelle (20) eine untere Ladungstransportschicht (4) umfasst, die aus einer Monoschicht selbstassemblierter Moleküle zusammengesetzt ist, **dadurch gekennzeichnet, dass** die Monoschicht selbstassemblierter Moleküle (4) durch kovalente Si-C-Bindungen mit dem dotierten Silizium des Tunnelübergangs (30) gepfropft ist.

2. Mehrschichtstruktur (100) nach Anspruch 1, wobei das Silizium des Tunnelübergangs (30) ausgewählt ist aus hydriertem und dotiertem amorphem Silizium, hydriertem und dotiertem polykristallinem Silizium, hydriertem und dotiertem mikrokristallinem Silizium, hydriertem und dotiertem nanokristallinem Silizium, hydriertem und dotiertem sauerstoffhaltigem nanokristallinem Silizium oder hydriertem und dotiertem kohlenstoffhaltigem nanokristallinem Silizium.

3. Mehrschichtstruktur (100) nach einem der Ansprüche 1 bis 2, wobei die Monoschicht selbstassemblierter Moleküle (4) aus ersten Fragmenten der Formel I oder der Formel II besteht, die durch kovalente Bindungen mit dem Silizium verbunden sind, um eine Lochtransportschicht zu bilden.

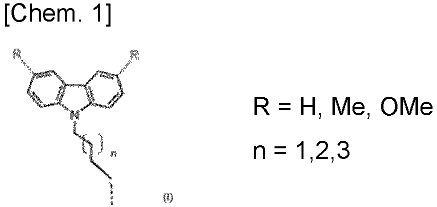

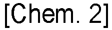

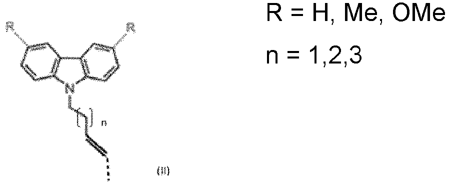

4. Mehrschichtstruktur (100) nach einem der Ansprüche 1 bis 2, wobei die Monoschicht selbstassemblierter Moleküle (4) aus zweiten Fragmenten der Formel III bis VI besteht, die durch kovalente Bindungen mit dem Silizium verbunden sind, um eine Elektronentransportschicht zu bilden.

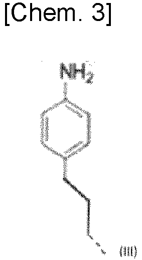

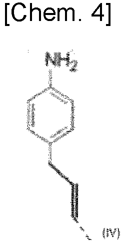

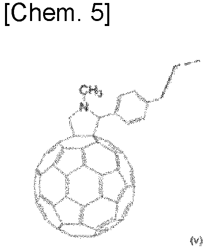

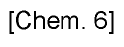

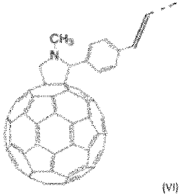

5. Mehrschichtstruktur (100) nach einem der Ansprüche 1 bis 4, wobei der Tunnelübergang (30) eine untere Schicht und eine obere Schicht umfasst, wobei mindestens eine der oberen Schicht und der unteren Schicht eine n-Schicht (3n) oder eine p-Schicht (3p) ist.

6. Mehrschichtstruktur (100) nach Anspruch 5, wobei die untere Schicht des Tunnelübergangs (30) eine n-Schicht (3n) oder eine p-Schicht (3p) ist und die Monoschicht selbstassemblierter Moleküle (4) mindestens zum Teil die obere Schicht bildet.

7. Mehrschichtstruktur (100) nach einem der Ansprüche 5 bis 6, wobei die untere Schicht des Tunnelübergangs (30) eine Schicht zur Auswahl der Ladungen (9n, 9p) der unteren Teilzelle (10) aus Silizium bildet.

8. Mehrschichtstruktur (100) nach einem der Ansprüche 1 bis 7, wobei die Oberfläche der dotierten Siliziumschicht an der Grenzfläche zwischen der unteren Teilzelle (10) und der oberen Teilzelle (20) frei von nativem Oxid ist.

9. Verfahren zur Herstellung der Mehrschichtstruktur (100) nach Anspruch 1 bis 8, wobei das Verfahren die folgenden Schritte umfasst:
- a) Bereitstellen der unteren Teilzelle (10) auf Siliziumbasis,
- b) Abscheiden mindestens der Schicht aus dotiertem und hydriertem Silizium, um mindestens die untere Schicht oder die obere Schicht (3n, 3p) des Tunnelübergangs (30) zu bilden,
- c) Bilden der Monoschicht selbstassemblierter Moleküle (4), um die Ladungstransportschicht zu bilden,
- d) Abscheiden der Perowskitschicht (2) auf der Monoschicht selbstassemblierter Moleküle (4).

10. Verfahren zur Herstellung der Mehrschichtstruktur (100) nach Anspruch 9, das vor dem Bilden der Monoschicht selbstassemblierter Moleküle (4) aus Schritt c) einen Schritt i) des Anwendens einer Behandlung der Siliziumoberfläche durch eine wässrige Lösung einer Mischung aus 2 % HF und 1 % HCl umfasst, um das native Oxid zu entfernen.

## Claims

1. A multilayer structure (100) intended to form a tandem photovoltaic cell, the multilayer structure (100) comprising:
- a lower silicon-based sub-cell (10),
- an upper perovskite-based sub-cell (20),
- a tunnel junction (30) including doped silicon disposed at the interface of the lower sub-cell (10) and of the upper sub-cell (20),
the upper sub-cell (20) comprising a lower charge transport layer (4) composed of a monolayer of self-assembled molecules, **characterized in that** the monolayer of self-assembled molecules (4) is grafted with the doped silicon of the tunnel junction (30) by Si-C covalent bonds.

2. The multilayer structure (100) according to claim 1, wherein the silicon of the tunnel junction (30) is selected from hydrogenated and doped amorphous silicon, hydrogenated and doped polycrystalline silicon, hydrogenated and doped microcrystalline silicon, hydrogenated and doped nanocrystalline silicon, hydrogenated and doped oxygenated nanocrystalline silicon, or hydrogenated and doped carbonaceous nanocrystalline silicon.

3. The multilayer structure (100) according to any of claims 1 and 2, wherein the monolayer of self-assembled molecules (4) consists of first fragments of formula I or formula II linked by covalent bonds to the silicon, so as to form a hole transport layer.

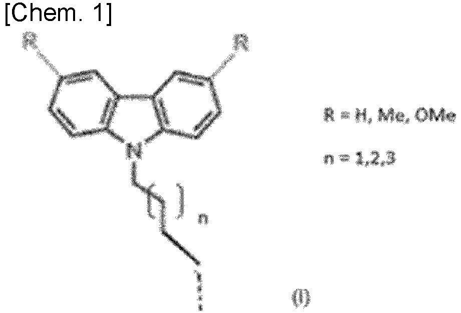

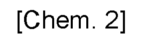

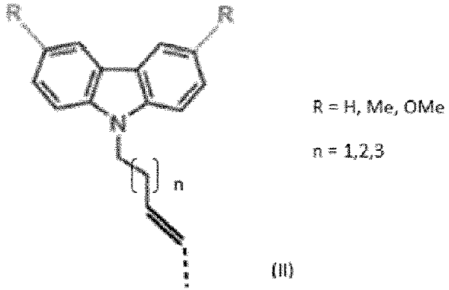

4. The multilayer structure (100) according to any of claims 1 and 2, wherein the monolayer of self-assembled molecules (4) consists of second fragments of formula III to VI linked by covalent bonds to the silicon, so as to form an electron transport layer.

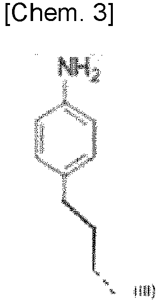

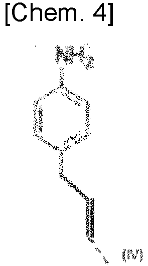

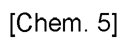

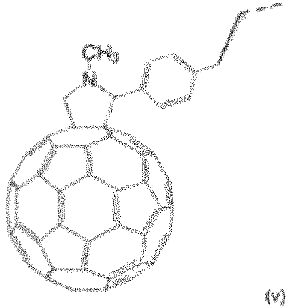

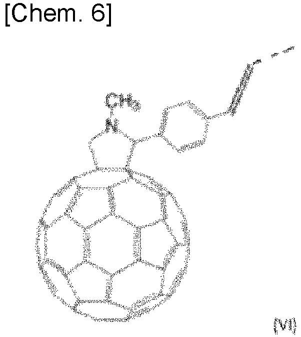

5. The multilayer structure (100) according to any of claims 1 to 4, wherein the tunnel junction (30) comprises a lower layer and an upper layer, at least one of the upper layer and of the lower layer is an n-type layer (3n) or a p-type layer (3p).

6. The multilayer structure (100) according to claim 5, wherein the lower layer of the tunnel junction (30) is an n-type layer (3n) or a p-type layer (3p) and the monolayer of self-assembled molecules (4) forms at least part of the upper layer.

7. The multilayer structure (100) according to any of claims 5 and 6, wherein the lower layer of the tunnel junction (30) forms a charge selection layer (9n, 9p) of the lower silicon sub-cell (10).

8. The multilayer structure (100) according to any of claims 1 to 7, wherein the surface of the doped silicon layer at the interface between the lower sub-cell (10) and the upper sub-cell (20) is devoid of native oxide.

9. A method for manufacturing the multilayer structure (100) according to claims 1 to 8, the method comprising the steps of:
- a) providing the lower silicon-based sub-cell (10),
- b) depositing at least the doped and hydrogenated silicon layer to form at least the lower layer or the upper layer (3n, 3p) of the tunnel junction (30),
- c) forming the monolayer of self-assembled molecules (4) so as to form the charge transport layer,
- d) depositing the perovskite layer (2) on the monolayer of self-assembled molecules (4).

10. The method for manufacturing the multilayer structure (100) according to claim 9 comprising, before the formation of the monolayer of self-assembled molecules (4) of step c), a step i) of applying a treatment of the silicon surface with an aqueous solution of a mixture of HF at 2% and HCl at 1%, so as to remove the native oxide.
